# DEMANDE DE BREVET EUROPEEN

(11) **EP 3 588 595 A1**
(43) Date de publication de la demande: **01.01.2020**
(21) Numéro de dépôt: 19181165.2
(22) Date de dépôt: 19.06.2019
(51) Int. Cl.: H01L 49/02, H01L 21/683

(54) **STRUCTURE MIM ET PROCEDE DE REALISATION D'UNE TELLE STRUCTURE**

(30) Priorité: 22.06.2018 FR 1855595
(71) Demandeur: Commissariat à l'énergie atomique et aux énergies alternatives, 75015 Paris (FR)
(72) Inventeur: LE RHUN, Gwenaël, 38054 GRENOBLE CEDEX 09 (FR); DIEPPEDALE, Christel, 38054 GRENOBLE CEDEX 09 (FR)
(74) Mandataire: Brevalex

(57) **Abrégé**

Procédé de réalisation d'une structure (100) de type MIM, comprenant :
- réalisation, sur un premier substrat, de première et deuxième couches de séparation disposées l'une contre l'autre ;
- réalisation, sur la deuxième couche de séparation (108), d'une couche isolante (110) comprenant un matériau de structure pérovskite ;
- réalisation d'une première couche d'or et/ou de cuivre (116) sur la couche isolante, formant au moins une partie d'une première électrode ;
- solidarisation de la première couche d'or et/ou de cuivre avec un deuxième substrat (104) ;
- séparation mécanique au niveau d'une interface entre les première et deuxième couches de séparation, la première couche de séparation restant solidaire du premier substrat et la deuxième couche de séparation restant solidaire de la couche isolante ;
la couche isolante étant disposée entre la première électrode et une deuxième électrode comportant au moins une couche métallique.

## Description

### DOMAINE TECHNIQUE ET ART ANTÉRIEUR

L'invention porte sur une structure de type Métal-Isolant-Métal, ou MIM, ainsi qu'un procédé de réalisation d'une telle structure. L'invention s'applique notamment au domaine de la réalisation de composants MEMS (microsystème électromécanique) et/ou NEMS (nanosystème électromécanique) et/ou de composants microélectroniques réalisés à partir de telles structures MIM. L'invention s'applique avantageusement à la réalisation de transducteurs piézoélectriques et/ou pyroélectriques et/ou ferroélectriques, et/ou de composants comprenant des condensateurs ou capacités MIM, et/ou de composants mémoires ferroélectriques, à partir de telles structures MIM.

De manière générale, les composants incluant une structure MIM sont réalisés tels que la résistivité des électrodes de cette structure soit la plus faible possible afin de minimiser les résistances de ligne ou résistances séries, et ainsi augmenter le facteur de qualité de ces composants. Pour cela, les électrodes de la structure MIM sont idéalement formées par des couches d'or ou de cuivre.

Le matériau isolant utilisé dans ces structures est généralement un matériau de structure pérovskite, comme par exemple du BST (Ba_{1-X}Sr_{X}TiO₃), du BCTZ (Ba_{X}Ca_{1-X}Ti_{Y}Zr_{1-Y}O₃) ou du PZT (Pb(Zr_{X},Ti_{1-X})O₃), qui nécessite, pour sa cristallisation, d'atteindre des températures comprises entre environ 400°C et 900°C. Or, de telles températures dégradent fortement l'or ou le cuivre.

Ainsi, en raison des températures atteintes pour la réalisation du matériau isolant, l'électrode inférieure sur laquelle le matériau isolant est cristallisé est généralement formée d'une unique couche de platine qui peut résister à de telles températures, et seule l'électrode supérieure, réalisée sur la couche isolante après sa cristallisation, est formée d'une couche d'or ou de cuivre. Toutefois, une électrode comprenant du platine et non de l'or ou du cuivre présente une résistivité élevée, et donc une résistance série plus importante, ce qui réduit les performances de la structure MIM dont le coefficient de qualité. On cherche donc à réduire au maximum la résistance série (ou résistance de ligne) des structures MIM, notamment lorsque ces structures forment des capacités utilisées pour des applications RF.

Le document EP 3 125 293 A2 décrit une électrode de structure MIM sur laquelle la couche isolante est cristallisée et qui présente une résistivité inférieure à celle d'une électrode de platine. Cette électrode particulière est formée d'une couche d'or sur laquelle formée une couche de RuO₂ formant une barrière de diffusion puis une couche de platine servant à la cristallisation du matériau de la couche isolante. Dans cette électrode, la couche barrière de diffusion permet d'éviter la diffusion de l'or dans la couche de platine lors de la cristallisation du matériau isolant sur cette électrode.

Bien qu'une telle électrode ait une plus faible résistivité qu'une couche de platine, ce type d'électrode inférieure ne permet pas d'éviter une diffusion depuis le matériau isolant dans les couches inférieures, notamment la diffusion du plomb lorsque le matériau isolant comporte du plomb (comme c'est le cas par exemple pour le PZT). De plus, la présence des couches de RuO₂ et de platine complexifie la structure de cette électrode et limite la valeur minimum de résistivité pouvant être atteinte.

### EXPOSÉ DE L'INVENTION

Un but de la présente invention est de proposer une structure de type MIM et un procédé de réalisation d'une telle structure ne présentant pas les inconvénients de l'art antérieur, c'est-à-dire dont la réalisation n'impose pas la présence de couches de RuO₂ et de platine pour former l'électrode inférieure et dont la résistivité de l'électrode inférieure soit inférieure à celle des structures MIM de l'art antérieur.

Pour cela, l'invention propose un procédé de réalisation d'une structure de type MIM, comprenant au moins :
- réalisation, sur une face d'un premier substrat, de première et deuxième couches de séparation disposées l'une contre l'autre et telles que la première couche de séparation soit disposée entre le premier substrat et la deuxième couche de séparation ;
- réalisation, sur la deuxième couche de séparation, d'au moins une couche isolante comprenant au moins un matériau de structure pérovskite ;
- réalisation d'au moins une première couche d'or et/ou de cuivre sur la couche isolante et destinée à former au moins une partie d'une première électrode de la structure de type MIM ;
- solidarisation de la première couche d'or et/ou de cuivre avec un deuxième substrat telle que la première couche d'or et/ou de cuivre soit disposée entre la couche isolante et le deuxième substrat ;
- séparation mécanique au niveau d'une interface entre les première et deuxième couches de séparation, telle que la première couche de séparation reste solidaire du premier substrat et que la deuxième couche de séparation reste solidaire de la couche isolante ;
et dans lequel la couche isolante est disposée entre la première électrode et une deuxième électrode comportant au moins une couche métallique.

Il est également proposé une structure de type Métal-Isolant-Métal, MIM, comprenant au moins :
- une première électrode comportant au moins une première et une deuxième couches d'or et/ou de cuivre solidarisées l'une contre l'autre ;
- une deuxième électrode comportant au moins une couche métallique ;
- une couche isolante comprenant au moins un matériau de structure pérovskite et disposée entre les première et deuxième électrodes.

Une telle structure MIM comporte une première électrode formée de deux couches d'or et/ou de cuivre solidarisées l'une contre l'autre. Ainsi, cette structure MIM peut être réalisée en formant sur un substrat temporaire une partie de cette structure MIM incluant notamment la couche isolante et l'une des deux couches d'or et/ou de cuivre, puis en reportant cette partie de la structure MIM sur un substrat définitif sur lequel se trouve l'autre des deux couches d'or et/ou de cuivre et en solidarisant les deux couches d'or et/ou de cuivre l'une avec l'autre.

De manière plus générale, le procédé de réalisation propose de réaliser la première couche d'or et/ou de cuivre, qui forme au moins une partie d'une première électrode de la structure MIM, sur la couche isolante elle-même disposée sur un substrat temporaire, puis de reporter cet ensemble sur un substrat définitif, correspondant au deuxième substrat, avec cette première couche d'or et/ou de cuivre disposée entre la couche isolante et le deuxième substrat. Du fait que la première couche d'or et/ou de cuivre est réalisée après la couche isolante, les températures atteintes lors de la réalisation de la couche isolante ne dégradent pas la première couche d'or et/ou de cuivre.

En outre, la structure MIM et le procédé proposés ici n'imposent pas que l'une des deux électrodes de la structure MIM comporte une couche de platine et/ou une couche de RuO₂.

Une telle structure MIM est compatible avec le fait que chaque électrode comporte de l'or et/ou du cuivre, et donc que les électrodes présentent chacune une faible résistivité.

Dans le procédé proposé ci-dessus, la deuxième électrode peut être formée par la deuxième couche de séparation et éventuellement au moins une couche d'or et/ou de cuivre réalisée sur cette deuxième couche de séparation, ou bien être formée par une couche différente, comprenant avantageusement de l'or et/ou du cuivre et réalisée sur la couche isolante après avoir supprimé la deuxième couche de séparation.

L'empilement de matériaux de cette structure MIM est en outre plus simple à réaliser en l'absence de couche de platine et/ou de couche de RuO₂ dans la première électrode.

De plus, ce procédé est avantageux lorsque le matériau de structure pérovskite de la couche isolante comporte du plomb, comme par exemple lorsque ce matériau correspond à du PZT ou un matériau de la même famille que le PZT, car il permet dans ce cas de s'affranchir des contraintes liées à l'intégration de ce matériau comportant le plomb, telles que le budget thermique nécessaire à son dépôt (qui n'est pas compatible avec un substrat comprenant des composants CMOS, ou un substrat de verre) et la diffusion du plomb dans les autres matériaux présents, du fait que ce matériau n'est pas formé sur le substrat définitif sur lequel repose la structure MIM à la fin du procédé.

De plus, à l'issue de la séparation mécanique à l'interface entre les première et deuxième couches de séparation, le premier substrat n'est pas détruit et peut être réutilisé pour réaliser un nouveau transfert de couche(s) depuis le premier substrat sur un autre deuxième substrat.

Dans l'ensemble du document, le terme « sur » est utilisé sans distinction de l'orientation dans l'espace de l'élément auquel ce rapporte ce terme. Par exemple, dans la caractéristique « sur une face d'un premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Chacune des première et deuxième couches d'or et/ou de cuivre peut correspondre à une unique couche d'or ou de cuivre, ou bien correspondre à un empilement de plusieurs couches d'or et/ou de cuivre.

La structure MIM peut être disposée sur un substrat. Lorsque cette structure MIM est utilisée pour la réalisation de composants RF (radiofréquence), ce substrat peut correspond à un substrat de silicium HR, ou à Haute Résistivité, c'est-à-dire dont la résistivité est supérieure à environ 0,5 kΩ.cm, voire supérieure à 1 kΩ.cm, afin de limiter les pertes dans ces composants.

La couche métallique de la deuxième électrode peut comporter du platine.

Les première et deuxième couches de la première électrode peuvent comporter de l'or ou du cuivre et peuvent être thermo-compressées l'une contre l'autre.

Le matériau de structure pérovskite peut avoir une composition chimique de type ABO₃, avec A et B correspondant à deux éléments chimiques différents l'un de l'autre.

La deuxième électrode peut comporter en outre une troisième couche d'or et/ou de cuivre telle que la couche métallique de la deuxième électrode soit disposée entre la troisième couche de la deuxième électrode et la couche isolante. Cette troisième couche d'or et/ou de cuivre permet d'abaisser la résistivité de la deuxième électrode, notamment lorsque le matériau de la couche métallique de la deuxième électrode présente une résistivité importante, comme par exemple le platine.

L'invention concerne également un dispositif comprenant au moins un transducteur piézoélectrique et/ou pyroélectrique et/ou ferroélectrique, et/ou un condensateur de type MIM, et/ou une mémoire ferroélectrique, incluant au moins une partie d'une telle structure de type MIM.

Le procédé peut comporter en outre, avant l'étape de solidarisation, une étape de réalisation d'au moins une deuxième couche d'or et/ou de cuivre sur le deuxième substrat, et dans lequel l'étape de solidarisation comporte une solidarisation des première et deuxième couches d'or et/ou de cuivre l'une contre l'autre, la première électrode de la structure de type MIM étant formée des première et deuxième couches d'or et/ou de cuivre.

Les première et deuxième couches formant la première électrode peuvent comporter de l'or ou du cuivre, et la solidarisation peut comporter la mise en oeuvre d'une thermocompression des première et deuxième couches l'une contre l'autre. Dans ce cas, il est possible d'avoir une ou plusieurs autres couches de matériaux présentes entre la première couche d'or et/ou de cuivre et la couche isolante, et/ou entre la deuxième couche d'or et/ou de cuivre et le deuxième substrat. La thermocompression peut être mise en oeuvre à une température inférieure ou égale à environ 400°C, voire inférieure à environ 150°C.

En variante, l'étape de solidarisation peut être mise en oeuvre :
- par l'intermédiaire d'au moins une couche adhésive réalisée sur la première couche d'or et/ou de cuivre, et/ou sur le deuxième substrat, ou
- par collage direct entre une première couche de collage réalisée sur la première couche d'or et/ou de cuivre, et une deuxième couche de collage réalisée sur le deuxième substrat.

La deuxième couche de séparation peut correspondre à la couche métallique de la deuxième électrode. Ainsi, cette deuxième couche de séparation peut être conservée après l'étape de séparation mécanique, pour servir de couche d'électrode pour les composants réalisés ensuite à partir des couches transférées sur le deuxième substrat. En variante, il est possible de supprimer la deuxième couche de séparation pour déposer ensuite le ou les métaux souhaités pour former la deuxième électrode, ou bien de déposer une ou plusieurs couches métalliques supplémentaires sur la deuxième couche de séparation.

Le procédé peut comporter en outre, après l'étape de séparation mécanique, une étape de réalisation d'une troisième couche d'or et/ou de cuivre sur la deuxième couche de séparation. Cette troisième couche d'or et/ou de cuivre permet de réduire la résistivité de la deuxième électrode, notamment lorsque la couche métallique de la deuxième électrode correspond à la deuxième couche de séparation qui comporte du platine.

La deuxième couche de séparation peut être configurée pour former une couche de cristallisation du matériau de structure pérovskite, et la réalisation de la couche isolante peut comporter une cristallisation du matériau de structure pérovskite sur la deuxième couche de séparation.

L'étape de solidarisation peut former un empilement de différents matériaux choisis tels que l'interface entre les première et deuxième couches de séparation correspond à celle, parmi toutes les interfaces de l'empilement, ayant la plus faible force d'adhérence, et :
- l'une des première et deuxième couches de séparation peut comporter au moins du SiO₂ et/ou du nitrure de silicium (tel que du SiN et/ou du Si₃N₄) et l'autre des première et deuxième couches de séparation peut comporter au moins un métal noble, et/ou
- le procédé peut comporter, entre l'étape de réalisation des première et deuxième couches de séparation et l'étape de solidarisation, la mise en oeuvre d'au moins une étape réduisant une force d'adhérence initiale de l'interface entre les première et deuxième couches de séparation.

Dans ce procédé, l'interface au niveau de laquelle la séparation mécanique est réalisée peut être définie au préalable par un choix judicieux des matériaux des première et deuxième couches de séparation engendrant naturellement une faible force d'adhérence à cette interface. En utilisant d'un côté un métal noble et de l'autre du SiO₂ et/ou du nitrure de silicium pour former les première et deuxième couches de séparation, une faible force d'adhérence est obtenue à l'interface de ces deux couches de séparation, sans avoir à mettre en oeuvre d'étape spécifique. Ainsi, après avoir solidarisé les deux substrats l'un à l'autre, la séparation mécanique réalisée au niveau de l'interface entre les première et deuxième couches de séparation ne dégrade pas les autres couches car c'est l'interface entre les première et deuxième couches de séparation qui présente la plus faible force d'adhérence parmi toutes les interfaces de l'empilement obtenu en solidarisant les premier et deuxième substrats entre eux.

L'utilisation d'un métal noble pour former l'une des première et deuxième couches de séparation a pour avantage d'éviter une oxydation de cette couche de séparation au contact de l'autre couche de séparation qui comporte le SiO₂ et/ou le nitrure de silicium, notamment de la cristallisation du matériau de la couche isolante.

En variante ou en complément de la réalisation des première et deuxième couches de séparation à partir d'un métal noble et de SiO₂ et/ou de nitrure de silicium, la force d'adhérence à l'interface entre les première et deuxième couches de séparation peut être réduite en mettant en oeuvre une étape spécifique, comme par exemple la formation de cavités à cette interface.

L'expression « toutes les interfaces de l'empilement » désigne toutes les interfaces formées entre deux couches successives (disposées l'une directement contre l'autre) de l'empilement.

La couche de séparation comportant du SiO₂ et/ou du nitrure de silicium peut correspondre à une couche de SiO₂ ou de nitrure de silicium, ou à un empilement de SiO₂ et de nitrure de silicium.

Le métal noble correspond à l'un ou plusieurs des matériaux suivants : platine (Pt), or (Au), argent (Ag), rhodium (Rh), osmium (Os), palladium (Pd), ruthénium (Ru), iridium (Ir).

Lorsque le métal noble est destiné à être exposé à de forts budgets thermiques, par exemple jusqu'à une température égale à environ 850°C, ce métal noble comporte avantageusement du platine et/ou du palladium. Lorsque le métal noble est destiné à être exposé à des températures moins importantes, comme par exemple des températures inférieures ou égales à environ 400°C, les autres métaux nobles (Au, Ag, Rh, Os, Ru, Ir) peuvent être utilisés pour former cette couche de métal noble.

La force d'adhérence de l'interface entre les première et deuxième couches de séparation peut être inférieure ou égale à environ 1,5 J/m², ou de préférence inférieure ou égale à environ 1 J/m². A titre d'exemple, la force d'adhérence entre les première et deuxième couches de séparation avec l'une comprenant du SiO₂ et l'autre du platine est égale à environ 1 J/m².

La force d'adhérence entre deux couches de matériaux peut être mesurée par la méthode dite d'insertion de lame décrite par exemple dans le document W. P. Mazsara et al., « Bonding of silicon wafers for silicon-on-insulator », Journal of Applied Physics 64, p. 4943, 1988.

Après la séparation au niveau de l'interface entre les première et deuxième couches de séparation, la surface libre de la couche de séparation qui comporte le métal noble a une très faible rugosité. Il n'est donc pas nécessaire de mettre en oeuvre un polissage après avoir avec mis en oeuvre l'étape de séparation mécanique. De manière avantageuse, le métal noble peut comporter du platine.

Le premier substrat peut comporter du semi-conducteur, par exemple du silicium.

Le deuxième substrat peut comporter du semi-conducteur, par exemple du silicium, ou du verre, du saphir.

Le procédé peut être tel que :
- le matériau de structure pérovskite comporte du plomb ;
- ladite une des première et deuxième couches de séparation comporte du SiO₂ ;
- ladite au moins une étape réduisant la force d'adhérence initiale de l'interface entre les première et deuxième couches de séparation comporte la mise en oeuvre d'au moins un traitement thermique formant, à l'interface entre les première et deuxième couches de séparation, un alliage de plomb et de SiO₂ en phase liquide, puis d'un refroidissement formant des cavités à l'interface entre les première et deuxième couches de séparation.

De telles cavités contribuent, seules ou en complément des matériaux choisis pour former les première et deuxième couches de séparation, à l'obtention de la faible force d'adhérence à l'interface entre les première et deuxième couches de séparation.

Le procédé peut comporter en outre :
- entre la réalisation de la couche isolante et la réalisation de la première couche d'or et/ou de cuivre, la réalisation d'une première couche d'accroche et/ou d'une première couche barrière de diffusion sur la couche isolante, la première couche d'or et/ou de cuivre étant réalisée ensuite sur la première couche d'accroche et/ou sur la première couche barrière de diffusion, et/ou
- avant la réalisation de la deuxième couche d'or et/ou de cuivre, la réalisation d'une deuxième couche d'accroche et/ou d'une deuxième couche barrière de diffusion sur le deuxième substrat, la deuxième couche d'or et/ou de cuivre étant réalisée ensuite sur la deuxième couche d'accroche et/ou sur la deuxième couche barrière de diffusion.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent les étapes d'un procédé de réalisation d'une structure de type MIM, selon un mode de réalisation particulier;
- la figure 4 représente un empilement de matériaux obtenu au cours du procédé de réalisation de la structure MIM, selon une variante de réalisation ;
- la figure 5 représente schématiquement une capacité MIM obtenue après gravure de la structure MIM réalisée.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

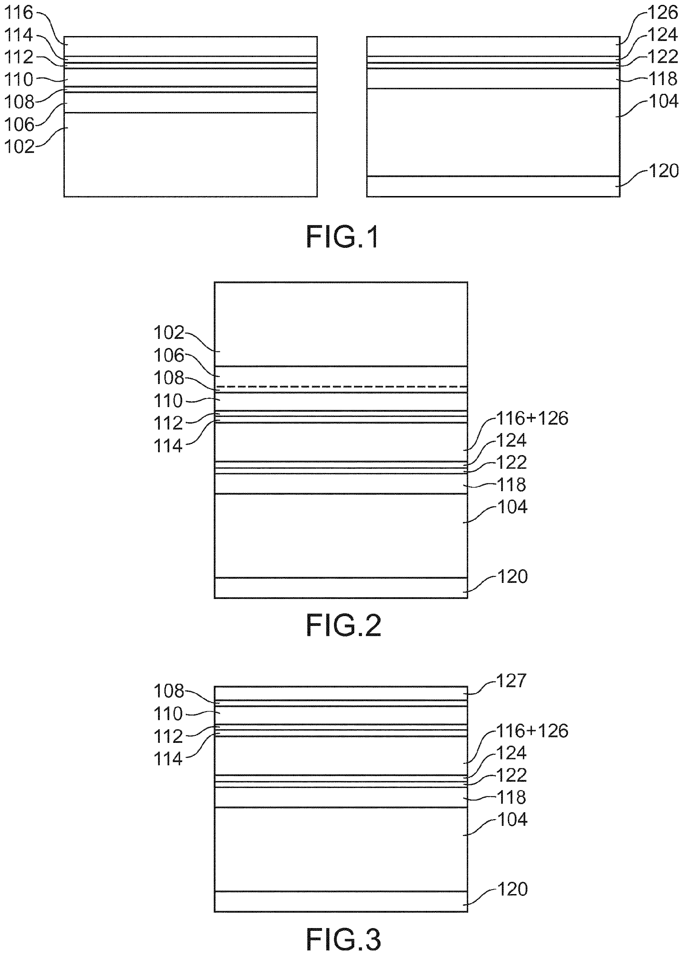

On se réfère aux figures 1 à 3 qui représentent les étapes d'un procédé de réalisation d'une structure MIM 100 selon un mode de réalisation particulier.

Comme représenté sur la figure 1, une première partie de la structure MIM 100 est préparée sur un premier substrat 102, également appelé substrat donneur. Les couches ou éléments réalisés sur le premier substrat 102 seront par la suite transférés sur un deuxième substrat 104, également appelé substrat receveur.

Le premier substrat 102 correspond ici à un substrat de semi-conducteur comprenant par exemple du silicium, et dont l'épaisseur est par exemple comprise entre environ 100 µm et 1 mm.

Le deuxième substrat 104 comporte au moins un matériau correspondant par exemple à un semi-conducteur tel que du silicium, ou du verre, ou du saphir. L'épaisseur du deuxième substrat 104 est par exemple égale à plusieurs centaines de microns. La nature du matériau du deuxième substrat 104 et son épaisseur dépendent notamment du type de composants qui seront réalisés à partir de la structure MIM 100.

Une interface de séparation, qui servira par la suite pour séparer les premier et deuxième substrats 102, 104 l'un de l'autre, est formée sur le premier substrat 104. Cette interface de séparation est formée entre une première couche de séparation 106 qui est disposée sur le premier substrat 104 et une deuxième couche de séparation 108 qui est disposée sur la première couche de séparation 106.

Dans le mode de réalisation particulier décrit ici, cette interface de séparation correspond à une interface de faible force d'adhérence formée entre la première couche de séparation 106 qui comprend du SiO₂ et/ou du nitrure de silicium tel que du SiN et/ou du Si₃N₄, et la deuxième couche de séparation 108 qui comprend au moins un métal noble. La faible force d'adhérence entre les couches de séparation 106, 108 est obtenue ici grâce la nature des matériaux des couches de séparation 106, 108 qui n'adhèrent que faiblement l'un à l'autre. Le matériau de la première couche de séparation 106 peut correspondre avantageusement à du SiO₂. La première couche de séparation 106 est par exemple réalisée par oxydation thermique de la face supérieure du premier substrat 102. L'épaisseur de la première couche de séparation 106 est par exemple comprise entre environ 1 nm et 20 µm, et ici égale à environ 500 nm.

Le métal noble de la deuxième couche de séparation 108 comporte au moins l'un des éléments suivants : platine, or, argent, rhodium, osmium, palladium, ruthénium, iridium. L'épaisseur de la deuxième couche de séparation 108 est par exemple comprise entre environ 1 nm et 200 nm. Cette deuxième couche de séparation 108 est par exemple formée par un dépôt du métal souhaité, par exemple de type PVD (dépôt physique en phase vapeur).

Une couche isolante 110 comprenant au moins un matériau de structure pérovskite est réalisée sur la deuxième couche de séparation 108. Dans le mode de réalisation particulier décrit ici, le matériau de structure pérovskite est formé par cristallisation sur la deuxième couche de séparation 108 qui forme donc une couche de cristallisation de ce matériau. Pour cela, la deuxième couche de séparation 108 comporte du platine.

Le matériau de structure pérovskite de la couche isolante 110 a par exemple une composition chimique de type ABO₃, avec A et B correspondant à deux éléments chimiques différents l'un de l'autre. De manière avantageuse, ce matériau correspond à du BST ou du PZT ou du BCTZ ou du STO. D'autre matériaux de structure pérovskite sont toutefois utilisables, comme par exemple du KNN (KNa_{X}Nb_{1-X}O₃), et dont l'épaisseur est par exemple comprise entre environ 1 nm et 20 µm et ici égale à environ 500 nm. La nature du matériau cristallisé pour former la couche isolante 110 ainsi que l'épaisseur de cette couche isolante 110 dépendent notamment du type des composants qui seront réalisés à partir de la structure MIM 100. Le matériau de la couche isolante 110 est par exemple déposé par un procédé de type sol-gel. Le matériau de la couche isolante 110 est alors obtenu par une succession d'étapes d'étalements de solution sol-gel par spin coating et de recuits de calcination (pour éliminer les organiques) et de cristallisation/densification. Le nombre de couches étalées est fonction de l'épaisseur finale voulue, sachant qu'une monocouche cristallisée a typiquement une épaisseur comprise entre environ 1 nm et 150 nm suivant la concentration de la solution utilisée. Lors de la formation ou du recuit du matériau de la couche isolante 110 la température maximale atteinte est par exemple comprise entre environ 400°C et 900°C.

Une première couche d'accroche 112 et une première couche 114 formant une barrière de diffusion sont ensuite formées sur la couche isolante 110. La première couche d'accroche 112 permet la bonne tenue de la première couche barrière 114 sur la couche isolante 110, et la première couche barrière 114 est destinée à éviter, lors de la solidarisation ultérieure entre les couches destinées à former ensemble une première électrode de la structure MIM 100, une diffusion d'atomes issus des couches solidarisées de cette première électrode dans la couche isolante 110.

Dans le mode de réalisation particulier décrit ici, la première couche d'accroche 112 comporte par exemple du W et/ou du Ti et/ou du Cr et/ou du Ru, ou tout autre matériau pouvant être déposé correctement sur la couche isolante 110 et permettant le dépôt ultérieur de la première couche barrière 114. L'épaisseur de la première couche d'accroche 112 est par exemple égale à environ 10 nm, et plus généralement comprise entre environ 5 nm et 10 nm. De plus, la première couche barrière 114 comporte par exemple du WN et/ou du TiN, et a une épaisseur par exemple inférieure ou égale à environ 60 nm.

La première partie de la structure MIM 100 préparée sur le premier substrat 102 est achevée en déposant une première couche d'or et/ou de cuivre 116 sur la première couche barrière 114. Cette première couche d'or et/ou de cuivre 116 est destinée à servir de couche de solidarisation par thermocompression avec une autre couche d'or et/ou de cuivre, et à former ensuite avec cette autre couche d'or et/ou de cuivre la première électrode de la structure MIM 100. L'épaisseur de cette première couche d'or et/ou de cuivre 116 est par exemple comprise entre environ 20 nm et 2 µm.

Parallèlement à la réalisation de la première partie de la structure MIM 100 sur le premier substrat 102, une deuxième partie de la structure MIM 100 est réalisée sur le deuxième substrat 104, et est également représentée sur la figure 1.

Une couche d'isolation électrique 118 est tout d'abord réalisée sur le deuxième substrat 104 qui correspond ici à un substrat de semi-conducteur, par exemple de silicium. Cette couche d'isolation électrique 118 comporte par exemple de l'oxyde de semi-conducteur correspondant avantageusement à du SiO₂. La couche 118 est par exemple réalisée par oxydation thermique de la face supérieure du deuxième substrat 104. Cette oxydation thermique forme une couche d'oxyde 120 similaire à la couche 118 au niveau de la face arrière du deuxième substrat 104 (une telle couche d'oxyde peut être présente en face arrière du premier substrat 102). L'épaisseur de la couche d'isolation électrique 118 est par exemple comprise entre environ 200 nm et 5 µm, et ici égale à environ 500 nm.

Une deuxième couche d'accroche 122 et une deuxième couche 124 formant une barrière de diffusion sont ensuite formées sur la couche d'isolation électrique 118. La deuxième couche d'accroche 122 permet la bonne tenue de la deuxième couche barrière 124 sur la couche 118, et la deuxième couche barrière 114 est destinée à éviter, lors de la solidarisation ultérieure entre les couches destinées à former ensemble une première électrode de la structure MIM 100, une diffusion d'atomes issus des couches solidarisées de cette première électrode dans la couche d'isolation 118 et dans le deuxième substrat 104.

Dans le mode de réalisation particulier décrit ici, la deuxième couche d'accroche 122 comporte par exemple du W et/ou du Ti et/ou du Cr et/ou du Ru, ou tout autre matériau pouvant être déposé correctement sur la couche d'isolation 118 et permettant le dépôt ultérieur de la deuxième couche barrière 124. L'épaisseur de la deuxième couche d'accroche 122 est par exemple égale à environ 10 nm, et plus généralement comprise entre environ 5 nm et 10 nm. De plus, la deuxième couche barrière 124 comporte par exemple du WN et/ou du TiN, et a une épaisseur par exemple inférieure ou égale à environ 60 nm.

La deuxième partie de la structure MIM 100 préparée sur le deuxième substrat 104 est achevée en déposant une deuxième couche d'or et/ou de cuivre 126 sur la deuxième couche barrière 124. Cette deuxième couche d'or et/ou de cuivre 126 est destinée à servir de couche de solidarisation par thermocompression avec la première couche d'or et/ou de cuivre 116, et à former ensuite avec la première couche d'or et/ou de cuivre 116 la première électrode de la structure MIM 100. L'épaisseur de cette deuxième couche d'or et/ou de cuivre 116 est par exemple comprise entre environ 20 nm et 2 µm, et par exemple similaire à celle de la première couche d'or et/ou de cuivre 116.

Afin de pouvoir réaliser une thermocompression entre les couches 116, 126, ces deux couches comportent un même matériau, ici de l'or ou du cuivre. A titre d'exemple, les première et deuxième couches d'or et/ou de cuivre 116, 126 peuvent comporter du cuivre et avoir chacune une épaisseur égale à environ 500 nm. Selon un autre exemple de réalisation, les première et deuxième couches d'or et/ou de cuivre 116, 126 peuvent comporter de l'or, et peuvent chacune avoir une épaisseur égale à environ 50 nm.

En variante, il est toutefois possible que l'une et/ou l'autre de ces couches 116,126 correspondent à un empilement de plusieurs couches différentes, par exemple un empilement d'une première couche de cuivre et d'une deuxième couche d'or. La thermocompression est dans ce cas réalisée entre les deux couches d'or de chacun de ces empilements.

Comme représenté sur la figure 2, les première et deuxième couches d'or et/ou de cuivre 116, 126 sont solidarisées l'une à l'autre par la mise en oeuvre d'une thermocompression. Ces deux couches thermocollées l'une à l'autre forment ensemble la première électrode de la structure MIM 100. Ce collage par thermocompression est par exemple mis en oeuvre à une température comprise entre environ 20°C et 400°C, en appliquant une force de compression comprise entre environ 1 kN et 50 kN, et pendant une durée comprise entre environ 1 min et 30 min. Les paramètres de mise en oeuvre de cette thermocompression sont adaptés notamment en fonction des propriétés des couches d'or et/ou de cuivre 116, 126.

Au sein de l'empilement ainsi obtenu, l'interface de faible force d'adhérence formée entre les couches de séparation 106, 108 correspond, parmi toutes les interfaces de l'empilement, à celle qui présente la plus faible force d'adhérence entre deux couches successives de l'empilement.

La structure MIM 100 est achevée en réalisant une séparation mécanique au niveau de l'interface entre les première et deuxième couches de séparation 106, 108, cette interface étant représentée en trait pointillé sur la figure 2. Cette séparation mécanique est par exemple réalisée en introduisant une lame entre les deux wafers.

A l'issue de cette séparation, une couche d'or et/ou de cuivre 127 est déposée sur la deuxième couche de séparation. La structure MIM 100 obtenue est représentée sur la figure 3. Cette structure MIM 100 est notamment formée de la couche isolante 110 disposée entre la première électrode, formée par les couches 116 et 126 thermocollées l'une à l'autre, et une deuxième électrode formée ici par la deuxième couche de séparation 108 qui comporte du platine et la couche 127 d'or et/ou de cuivre.

Après la séparation mécanique réalisée entre les couches de séparation 106, 108, la première couche de séparation 106 reste solidaire du premier substrat 102. La séparation entre les première et deuxième couches de séparation 106, 108 est nette et propre. Ce premier substrat 102 peut être réutilisé pour réaliser par exemple une nouvelle structure MIM en mettant de nouveau en oeuvre les étapes précédemment décrites avec un nouveau deuxième substrat 104.

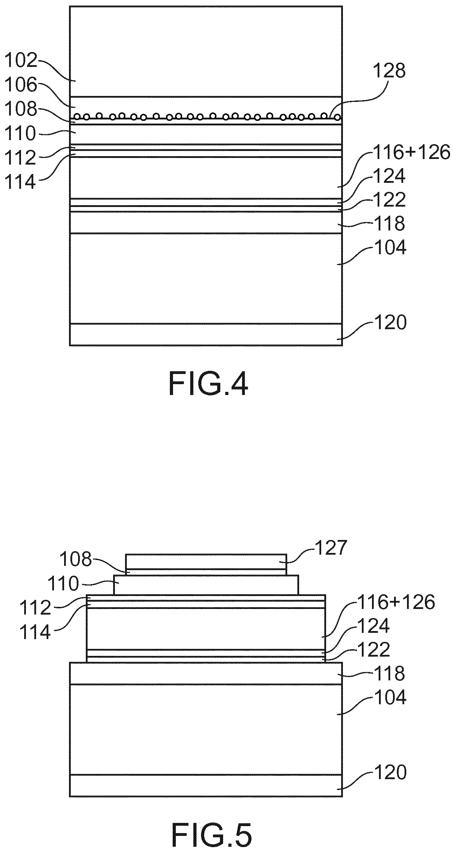

A partir de la structure MIM 100 ainsi réalisée, il est possible de structurer/graver les couches de cette structure selon les motifs souhaités pour former par exemple des transducteurs piézoélectriques et/ou pyroélectriques et/ou ferroélectriques, des condensateurs/capacités de type MIM, ou encore des mémoires ferroélectriques. A titre d'exemple, la figure 5 représente schématiquement et de manière simplifiée une capacité MIM obtenue après gravure des couches de la structure MIM 100.

Lorsque les composants réalisés à partir de la structure MIM 100 correspondent à des composants RF, le deuxième substrat 104 sur lequel la structure MIM 100 est réalisée correspond avantageusement à un substrat de silicium HR, ou à Haute Résistivité.

Dans le mode de réalisation particulier décrit ci-dessus, la deuxième électrode de la structure MIM 100 est formée par la deuxième couche de séparation 108 et par la couche d'or et/ou de cuivre 127 qui permet de réduire la résistivité globale de la deuxième électrode de la structure MIM 100 par rapport à une deuxième électrode qui comporterait uniquement la deuxième couche de séparation 108. Selon une autre variante, après la séparation mécanique réalisée à l'interface des couches de séparation 106, 108, il est possible de graver la deuxième couche de séparation 108, puis de déposer une ou plusieurs couches métalliques formant la deuxième électrode de la structure MIM 100, par exemple une couche d'or et/ou de cuivre ayant l'épaisseur souhaitée pour former à elle seule cette deuxième électrode.

En variante du mode de réalisation particulier décrit ci-dessus, il est possible de ne pas réaliser la première couche barrière 114 et/ou la deuxième couche barrière 124. En effet, si la température atteinte lors de la thermocompression et les épaisseurs des couches d'or et/ou de cuivre 116, 126 sont telles que des atomes d'or et/ou de cuivre ne se diffusent pas dans la couche isolante 110 et/ou dans le deuxième substrat 104, il est alors possible de ne pas réaliser l'une et/ou l'autre de ces couches barrière 114, 124. Toutefois, même en l'absence de la première couche barrière 114 et/ou de la deuxième couche barrière 124, les première et deuxième couches d'accroche 112, 122 permettent d'obtenir une bonne adhérence des couches 116, 126.

Dans l'exemple de réalisation décrit ci-dessus, la face arrière du deuxième substrat 104 est recouverte par la couche d'oxyde 120. En variante, il est possible de supprimer cette couche d'oxyde 120 en réalisant une désoxydation de la face arrière du deuxième substrat 104, comme pour le premier substrat 102.

Dans le mode de réalisation précédemment décrit, la solidarisation est réalisée par thermocompression entre les couches 116 et 126.

Selon un autre mode de réalisation, il est possible de réaliser la structure 100 en mettant en oeuvre les étapes suivantes.

L'empilement de couches 106, 108, 110, 112, 114 et 116 est tout d'abord réalisé sur le premier substrat 102. Dans cet autre mode de réalisation, la couche d'or et/ou de cuivre 116 est configurée pour former à elle seule la première électrode de la structure 100. Ainsi, la couche 116 est formée avec une épaisseur correspondant à l'épaisseur finale souhaitée pour cette première électrode.

Les couches 118, 122, 124 sont également réalisées sur le deuxième substrat 104.

Au moins une couche adhésive, par exemple une couche de colle polymère, est ensuite réalisée sur la couche 124 (à la place de la couche d'or et/ou de cuivre 126), et/ou sur la couche d'or et/ou de cuivre 116. Il est donc possible de réaliser une couche adhésive sur la couche 124, et/ou de réaliser une couche adhésive sur la couche d'or et/ou de cuivre 126.

Les deux substrats 102, 104 sont ensuite solidarisés l'un à l'autre par l'intermédiaire de la ou des couches adhésives qui se retrouve(nt) disposée(s) entre la couche 116 et la couche 124.

La séparation mécanique est ensuite réalisée à l'interface entre les couches 106, 108 afin de séparer le premier substrat 102 vis-à-vis des du deuxième substrat 104 et des autres couches solidaires du deuxième substrat 104.

Selon un autre mode de réalisation, il est possible de réaliser la structure 100 en mettant en oeuvre les étapes suivantes.

L'empilement de couches 106, 108, 110, 112, 114 et 116 est tout d'abord réalisé sur le premier substrat 102. Dans cet autre mode de réalisation, la couche d'or et/ou de cuivre 116 est configurée pour former à elle seule la première électrode de la structure 100. Ainsi, la couche 116 est formée avec une épaisseur correspondant à l'épaisseur finale souhaitée pour cette première électrode.

Les couches 118, 122, 124 sont également réalisées sur le deuxième substrat 104.

Une première couche de collage direct, comprenant par exemple du SiO₂, Si ou SiN, est ensuite réalisée sur la couche d'or et/ou de cuivre 116, et une deuxième couche de collage direct est réalisée sur la couche 124.

Les deux substrats 102, 104 sont ensuite solidarisés l'un à l'autre par collage direct, ou collage moléculaire, des première et deuxième couches de collage direct l'une contre l'autre.

La séparation mécanique est ensuite réalisée à l'interface entre les couches 106, 108 afin de séparer le premier substrat 102 vis-à-vis des du deuxième substrat 104 et des autres couches solidaires du deuxième substrat 104.

Dans les modes de réalisation et les variantes précédemment décrits, l'interface de faible force d'adhérence est formée grâce aux propriétés intrinsèques des matériaux des couches de séparation 106, 108, du fait que le SiO₂ et/ou le nitrure de silicium et un métal noble adhérent peu l'un à l'autre.

En variante, il est possible que la faible force d'adhérence de l'interface entre le substrat donneur (premier substrat 102) et les couches à transférer sur le substrat receveur (deuxième substrat 104) soit obtenue grâce à la mise en oeuvre d'au moins une étape spécifique dégradant volontairement les propriétés d'adhérence de cette interface et réduisant la force d'adhérence à cette interface entre les matériaux des première et deuxième couches de séparation 108, 110. A titre d'exemple, après ou lors du dépôt de la couche isolante 110 dont le matériau de structure pérovskite comporte du plomb, comme par exemple du PZT, il est possible de mettre en oeuvre un traitement thermique faisant diffuser des atomes de plomb issus du matériau de la couche isolante 110 vers le SiO₂ de la première couche de séparation 106, à travers la deuxième couche de séparation 108 qui comporte par exemple du platine. Avec un tel traitement thermique, par exemple mis en oeuvre à une température supérieure ou égale à environ 700°C, un mélange SiO₂ + Pb en phase liquide se forme à l'interface entre les première et deuxième couches de séparation 106, 108. Lorsque la température descend, des cavités se créent alors à cette interface, dans la couche formée du mélange de SiO₂ et de plomb.

La figure 4 représente la structure obtenue après l'étape de solidarisation. Cette structure comporte, à l'interface formée entre les couches de séparation 106, 108, des cavités 128 créées suite à la diffusion d'atomes de plomb issus du matériau de structure pérovskite de la couche isolante 110 dans le SiO₂ de la première couche de séparation 108. Ces cavités 128 réduisent l'adhérence entre les couches de séparation 106, 108.

Cette dégradation, ou réduction, de la force d'adhérence de l'interface entre les couches de séparation 106, 108 peut donc être réalisée lorsque les propriétés intrinsèques des matériaux utilisés pour ces couches de séparation 106, 108 n'engendrent pas, sans intervention supplémentaire, la formation d'une interface de faible force d'adhérence. Les couches de séparation 106, 108 peuvent dans ce cas être réalisées à partir de matériaux autres que du SiO₂ et/ou du nitrure de silicium et un métal noble. A titre d'exemple, la première couche de séparation 106 peut dans ce cas comporter du TiO₂ et/ou du ZrO₂ et/ou du ZnO. En variante, il est possible de réaliser de telles cavités 128 pour affaiblir encore plus la force d'adhérence à une interface correspondant à celle ayant la plus faible force d'adhérence dans tout l'empilement réalisé.

Dans le mode de réalisation précédemment décrit, le deuxième substrat 104 sur lequel la structure MIM 100 est réalisée correspond à une couche de matériau non structurée. En variante, il est possible que des cavités soient réalisées à travers au moins une partie de l'épaisseur du deuxième substrat 106, depuis la face arrière de ce deuxième substrat 106, afin que la structure MIM 100 puisse être utilisée pour former des membranes des dispositifs réalisés à partir de la structure MIM 100.

La structure MIM 100 réalisée peut avantageusement servir à la réalisation de composants formant des transducteurs électromécaniques intégrant des matériaux qui vont permettre de réaliser des fonctions d'actionneur et/ou de capteur. La fonction capteur est obtenue par l'effet piézoélectrique direct (une contrainte mécanique entraîne l'apparition de charges électriques dans le matériau) tandis que la fonction actionneur est obtenue par effet piézoélectrique inverse (dans ce cas une polarisation électrique externe au matériau entraîne une déformation mécanique de ce dernier).

Pour réaliser la fonction actionneur, un matériau piézoélectrique présentant un coefficient piézoélectrique transverse de coefficient d31 le plus élevé possible est généralement choisi. C'est le cas du PZT (ou du PZT dopé (La, Mn, Nb), du KNN, du BNT-BT, ou encore du PMN-PT).

Pour réaliser la fonction capteur, un matériau présentant le meilleur compromis entre un fort coefficient piézoélectrique transverse e31 et une faible permittivité diélectrique εᵣ, c'est-à-dire avec la plus grande Figure de Mérite FOM= e31/εᵣ, est généralement choisi. C'est le cas typiquement de l'AlN (ou encore de l'AlN dopé Sc).

Certains dispositifs MEMS / NEMS piézoélectriques fonctionnent à la fois en mode actionneur et en mode capteur. C'est le cas des PMUT (Transducteurs Ultrasonores Micro-usinés Piézoélectriques). Ils fonctionnent en actionneur pour émettre des ondes acoustiques (émission) et en capteur pour réceptionner les ondes acoustiques en retour (réception). Les dispositifs PMUT intègrent un même matériau piézoélectrique qui va permettre à la fois l'émission d'ondes ultrasonores (US) et la réception des ondes US en retour. Les transducteurs électromécaniques comportent très souvent sous forme de membrane type peau de tambour, c'est-à-dire une membrane (couche élastique + couche dite « motrice » (piézoélectrique ou autre)) suspendue au-dessus d'une cavité.

La structure MIM 100 réalisée peut servir à la réalisation d'une telle structure de transduction électromécanique.

Les différents exemples et variantes de réalisation décrits ci-dessus peuvent être combinés les uns avec les autres.

## Revendications

1. Procédé de réalisation d'une structure (100) de type MIM, comprenant au moins :
- réalisation, sur une face d'un premier substrat (102), de première et deuxième couches de séparation (106, 108) disposées l'une contre l'autre et telles que la première couche de séparation (106) soit disposée entre le premier substrat (102) et la deuxième couche de séparation (108) ;
- réalisation, sur la deuxième couche de séparation (108), d'au moins une couche isolante (110) comprenant au moins un matériau de structure pérovskite ;
- réalisation d'au moins une première couche d'or et/ou de cuivre (116) sur la couche isolante (110) et destinée à former au moins une partie d'une première électrode de la structure (100) de type MIM ;
- solidarisation de la première couche d'or et/ou de cuivre (116) avec un deuxième substrat (104) telle que la première couche d'or et/ou de cuivre (116) soit disposée entre la couche isolante (110) et le deuxième substrat (104) ;
- séparation mécanique au niveau d'une interface entre les première et deuxième couches de séparation (106, 108), telle que la première couche de séparation (106) reste solidaire du premier substrat (102) et que la deuxième couche de séparation (108) reste solidaire de la couche isolante (110) ;
et dans lequel la couche isolante (110) est disposée entre la première électrode et une deuxième électrode comportant au moins une couche métallique (108).

2. Procédé selon la revendication 1, comportant en outre, avant l'étape de solidarisation, une étape de réalisation d'au moins une deuxième couche d'or et/ou de cuivre (126) sur le deuxième substrat (104), et dans lequel l'étape de solidarisation comporte une solidarisation des première et deuxième couches d'or et/ou de cuivre (116, 126) l'une contre l'autre, la première électrode de la structure (100) de type MIM étant formée des première et deuxième couches d'or et/ou de cuivre (116, 126).

3. Procédé selon la revendication 2, dans lequel les première et deuxième couches (116, 126) formant la première électrode comportent de l'or ou du cuivre, et dans lequel la solidarisation comporte la mise en oeuvre d'une thermocompression des première et deuxième couches (116, 126) l'une contre l'autre.

4. Procédé selon la revendication 1, dans lequel l'étape de solidarisation est mise en oeuvre :
- par l'intermédiaire d'au moins une couche adhésive réalisée sur la première couche d'or et/ou de cuivre (116), et/ou sur le deuxième substrat (104), ou
- par collage direct entre une première couche de collage réalisée sur la première couche d'or et/ou de cuivre (116), et une deuxième couche de collage réalisée sur le deuxième substrat (104).

5. Procédé selon l'une des revendications précédentes, dans lequel la deuxième couche de séparation (108) correspond à la couche métallique (108) de la deuxième électrode.

6. Procédé selon la revendication 5, comportant en outre, après l'étape de séparation mécanique, une étape de réalisation d'une troisième couche d'or et/ou de cuivre (127) sur la deuxième couche de séparation (108).

7. Procédé selon l'une des revendications précédentes, dans lequel la deuxième couche de séparation (108) est configurée pour former une couche de cristallisation du matériau de structure pérovskite, et dans lequel la réalisation de la couche isolante (110) comporte une cristallisation du matériau de structure pérovskite sur la deuxième couche de séparation (108).

8. Procédé selon l'une des revendications précédentes, dans lequel l'étape de solidarisation forme un empilement de différents matériaux choisis tels que l'interface entre les première et deuxième couches de séparation (106, 108) correspond à celle, parmi toutes les interfaces de l'empilement, ayant la plus faible force d'adhérence, et dans lequel :
- l'une des première et deuxième couches de séparation (106) comporte au moins du SiO₂ et/ou du nitrure de silicium et l'autre des première et deuxième couches de séparation (108) comporte au moins un métal noble, et/ou
- le procédé comporte, entre l'étape de réalisation des première et deuxième couches de séparation (106, 108) et l'étape de solidarisation, la mise en oeuvre d'au moins une étape réduisant une force d'adhérence initiale de l'interface entre les première et deuxième couches de séparation (106, 108).

9. Procédé selon la revendication 8, dans lequel le métal noble comporte du platine.

10. Procédé selon l'une des revendications 8 et 9, dans lequel :
- le matériau de structure pérovskite comporte du plomb ;
- ladite une des première et deuxième couches de séparation (106) comporte du SiO₂;
- ladite au moins une étape réduisant la force d'adhérence initiale de l'interface entre les première et deuxième couches de séparation (106, 108) comporte la mise en oeuvre d'au moins un traitement thermique formant, à l'interface entre les première et deuxième couches de séparation (106, 108), un alliage de plomb et de SiO₂ en phase liquide, puis d'un refroidissement formant des cavités (128) à l'interface entre les première et deuxième couches de séparation (106, 108).
